Europäisches Patentamt

(19) **European Patent Office**

**Office européen des brevets**

(11) Publication number: **0 030 724**

**B1**

(12) **EUROPEAN PATENT SPECIFICATION**

(45) Date of publication of patent specification: **05.10.83**

(51) Int. Cl.³: **G 01 R 29/26**

(21) Application number: **80107867.6**

(22) Date of filing: **12.12.80**

(54) **Method and device for carrying out objective measurements on digital speech transmission systems.**

(30) Priority: **14.12.79 IT 6940479**

(43) Date of publication of application:
**24.06.81 Bulletin 81/25**

(45) Publication of the grant of the patent:
**05.10.83 Bulletin 83/40**

(84) Designated Contracting States:
**CH DE FR GB LI NL SE**

(56) References cited:
**DE - A - 2 151 981**
**DE - A - 2 406 001**
**DE - A - 2 649 264**

(73) Proprietor: **CSELT Centro Studi e Laboratori Telecomunicazioni S.p.A.**
**Via Guglielmo Reiss Romoli, 274**
**I-10148 Turin (IT)**

(72) Inventor: **Scagliola, Carlo**
**Via C. Fasciotti 59/28**
**I- 16159 Genova (IT)**
Inventor: **Billi, Roberto**
**Via Corsica, 3**
**Livorno (IT)**

(74) Representative: **Riederer Freiherr von Paar zu Schönau, Anton**
**Freyung 615 Postfach 2664**
**D-8300 Landshut (DE)**

Courier Press, Leamington Spa, England.

# Method of and device for carrying out objective measurements on digital speech transmission systems

The present invention relates to a method of carrying out objective measurements on a digital speech transmission system and to a device for carrying out the method, and thus relates to the technical field of quality measurements on speech transmission apparatuses.

It is known that according to the present technique objective and automatic quality measurements (that is measurements that do not require the intervention of human speakers and/or listeners) are more and more preferred as they are faster and simpler than subjective measurements. On the other hand subjective measurements supply more significant quality indications as the tested apparatuses are intended for human users. Therefore, if the objective measurements are chosen, they are to be effected so that their results are in good agreement with those of subjective measurements.

Generally, to effect objective measurements, a suitable input signal is sent into the system and a number of characteristics of the output and input signals are compared instant by instant. To obtain the agreement with the subjective measurements, problems are to be solved concerning the choice of the input signal and the quantities to be analysed.

As to the type of signal to be sent to the system, in case of PCM systems good results have been obtained by the use of sinusoids; in case of lower rate systems, as those of differential type, the use of a signal as similar as possible to the speech is preferable (e.g. an artificial signal with spectral characteristics like the average speech).

It is known to measure non-linearity distorsions, i.e. distorsions depending on the signal level, by measuring the intermodulation products of sinusoids at different frequencies sent into the system as test signals (DE—A—2 151 981 and 2 406 001) or by acting on the output signal of the system (DE—A—2 649 264).

As to the quantities to be analysed, in case of PCM systems a good objective indication of quality is obtained from the value of signal-to-noise ratio, that is from the ratio between the power of the signal sent to the system and that of an error signal, that can be the difference between the output and the input signal. In case of differential systems two different quantities have proved more suitable: the segmental signal-to-noise ratio (that is, a mean value of the measurements of signal-to-noise ratios relating to a number of time intervals into which the test period is divided) or a frequency weighting of said ratio (that is, signal-to-noise ratio is evaluated in different frequency bands into which the signal spectrum is divided and a weighted mean value of the obtained values as calculated, emphasizing the frequencies to which the human ear is more sensible); this measure is also the best suited to low rate coders in which there is also a spectral shaping of quantization noise.

It is to be taken into account that the choice of the type of measurement can affect the choice of the test signal and vice versa: for instance frequency weighting is incompatible with the use of a signal having only the characteristics of the average speech (that is stationary characteristics) but requires the use of real speech (what renders the measurement longer, as the results obtained from different voices have to be averaged) or of noises shaped in a particular way.

Therefore, to effect accurate measurements, a specific device for each kind of coder should be used; to avoid this complication a compromise solution for the signal input and the measurement type can be chosen, to detriment however of the good correspondence between objective and subjective measurements.

Once the problems concerning the test signal and the type of measurement have been solved there are still problems relating to the modalities of the measurement. In fact, as mentioned, the output and the input signals of the system are to be compared at every instant; then a perfect synchronization is necessary to ensure the comparison between corresponding signals. In addition, the systems introduce attenuations (or gains), linear filterings, delays, etc. that do not affect the signal quality, but affect the objective measurement and therefore are to be considered.

Presently, to solve the problems involved in the choice of the signal and of the type of measurement without resorting to specific devices for every type of apparatus, as well as the problems concerning the modalities of the measurements, a computer simulation of the system is performed and the system behaviour is studied in presence of an input signal suitable for simultation. This procedure presents the inconvenience that a mathematical model of the system is tested instead of the real system; then the approximations made to describe the system can result into quality indications that not always coincide with real quality, chiefly because of the influence of the linear factors represented by said attenuations, filterings, delays, etc. Besides, the simultation cannot be performed if the characteristics of the system are not exactly known.

The invention is to overcome these inconveniences. To this end, a method according to claim 1 and a device according to claim 7 for the objective measurements are provided that allow the effectuation of different kinds of measurements, according to the system type, with different kinds of input signals; that allow the elimination of the influence of the factors affecting only the result of the measurement without influencing the quality, and that do not require the knowledge of the system.

The invention will now be described with reference to the annexed drawings, that show a preferred embodiment of the invention given by way of example and not in a limiting sense, and in which:

Fig. 1 is a block diagram of the device;

Fig. 2 is a diagram of the filter reproducing the linear characteristics of the system;

Figs. 3 and 4 are functional diagrams of devices for quality measurements based on the computation of the total or segmental signal-to-noise ratio;

Fig. 5 is a functional diagram of a device for quality measurements based on the frequency weighting of segmental signal-to-noise ratio.

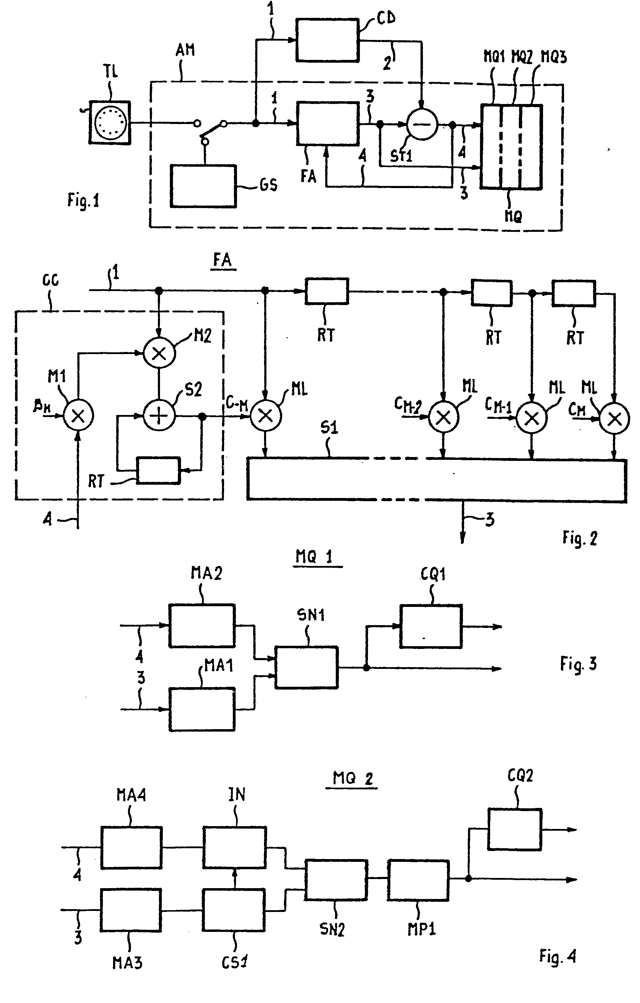

In Fig. 1 reference CD denotes a transmission system (e.g. a speech coder) whose quality is to be established, and reference AM denotes the device object of the invention. This basically comprises:

— a set of signal generators GS that supply some of the signals to be utilized for the tests. The system and the remaining elements of device Am can be connected alternatively to an external signal source, schematized by telephone TL or to this set of signal generators GS;
— an adapting filter FA connected in parallel to the system CD and designed to produce on the test signal (present on wire 1) the same effects as the linear part of the system CD;
— means MQ designed to compute the quality and connected to the output of filter FA and, through a subtractor ST1, to the output of the system CD.

The set of generators GS will advantageously comprise a white-noise generator, a generator of frequency shaped noise and a generator of a speech-like artifical signal; these kinds of signals in fact allow quality measurements practically on each type of speech coder.

Generator GS can be digital or analog. Considering for the sake of simplicity only the case of digital generators (that is the most interesting in the practice), the white noise generator can be a shift register with feed-back such as to originate pseudorandom binary sequences. The same shift register with feed-back, followed by a low-pass filter with the wanted transfer function, can be used as shaped noise generator. The generator of sinusoidal signals will consist of a read-only-memory cyclically read, wherein digital samples of the function have been previously stored. Finally, the generator of speech-like periodic artificial signals will comprise a read-only-memory storing samples of a periodic signal generated in the way described by G. Modena, S. Sandri, C. Scagliola in the paper "A mathematical model of an artificial signal for the testing of digital speech transmission systems", CSELT Rapporti Tecnici, Vol. VI, No. 1, March 1978. This memory is advantageously associated to another read-only-memory storing the samples of a slowly varying signal (e.g. an envelope signal) that are multiplied by the samples of the artifical signal. This way of operating eliminates the rigidity typical of the periodic signal and gives better correspondence with the results of subjective measurements.

Filter FA is an adaptive transversal filter that in a first operating phase, by using a first test signal generated by GS, identifies the characteristics of the linear part of the system CD generating a first error signal; once the identification has taken place, in a second operating phase corresponding to the real measurement, filter FA reproduces, on the same test signal or on a different one, the effects of said linear part, allowing the elimination of the contribution thereof from the output signal of transmission system CD. The adaptation of the coefficients is controlled by a second error signal, present on a wire 4 and supplied by subtracting circuit ST1 that subtracts the filter output signal (present on wire 3) from the system, e.g. coder, output signal (present on wire 2). The structure of FA is shown in detail in Fig. 2.

The means MQ computing the quality are advantageously apt to effect many kinds of quality measures; preferably they will extract a quality value from evaluations of signal-to-noise ratio; the choice of the type of evaluation chiefly depends on the nature of the system under test. The "signal" can be represented by the filter output signal and the "noise" by the second error signal outgoing from ST1.

The choice of the output signal of FA instead of the system CD input signal is due to the fact that said output signal, if the filter operates correctly, is not affected by the influence of possible amplifications or phase distortions, introduced by CD, which can emphasize or reduce the noise, thereby altering the measurement; at the output from FA there is the pure signal, that is subtracted from the signal outgoing from CD to obtain the noise.

If quality measurements based on the signal-to-noise ratio are effected, MQ will for instance comprise means for measuring the total and segmental signal-to-noise ratio and the frequency weighted segmental signal-to-noise ratio. By said three means good quality measurements can be obtained for a very wide range of systems such as coders, by using the test signals previously mentioned.

From these evaluations of signal-to-noise ratio, digital quality indications can be obtained by applying relations of the type IQ '' aX+b, where: IQ is the quality indication that can be expressed in a scale of nine values (from 1 to 9), higher values corresponding to better subjective quality; X is the value in dB of signal-to-noise ratio (total or segmental or frequency weighted segmental SNR); a, b are digital coefficients whose values depend on the kind of evaluation effected. Possible values of a, b for the three cited cases are reported in the paper "Perceptual and objective evaluation of speech processed by adaptive differential PCM" by B. McDermott, C. Scagliola and D. Goodman (The Bell System Technical Journal, Vol. 57, No. 5) and in the paper "Evaluation of Adaptive Speech Coders Under Noisy Channel Conditions" by C. Scagliola (B.S.T.J. Vol. 58, No. 6).

To make the description clearer, but without limiting the scope of the invention, particular measuring means MQ apt to effect the three above mentioned evaluations will be considered. To this purpose block MQ is represented as divided into three parts, i.e. measuring circuits MQ1, MQ2, MQ3.

Always by way of example it will be assumed that the evaluation of the total segmental and frequency weighted signal-to-noise ratio is effected according to the following definitions:

a) total signal-to-noise ratio:

$$SNR = 10 \, Log \frac{\Sigma_k \, s^2(k)}{\Sigma_k \, n^2(k)} \qquad (1)$$

where $s(k)$, $n(k)$ are the generic samples of the reference signal and of the noise, respectively, and the summation extends over all the samples used for the test;

b) segmental signal-to-noise ratio:

$$SNRS = \frac{1}{P} \sum_{p=0}^{P-1} 10 \, Log \frac{\sum_{j=1}^{J} s^2(j+pJ)}{\sum_{j=1}^{J} n^2(j+pJ)} \qquad (2)$$

where P is the number of time intervals or "segments" in which the test duration is subdivided; $s(j+pJ)$, $n(j+pJ)$ are the generic samples of reference signal or of noise, respectively, in the p-th segment, and J is the number of samples in each segment; for instance if the test period is subdivided into segments of 16 ms, J will be 128 (corresponding to a sampling frequency 8 kHz);

c) frequency weighted segmental signal-to-noise ratio:

$$SNRF = \frac{1}{P} \sum_{p=0}^{P-1} 10 \, Log \frac{1}{1 + \sum_{q=1}^{Q} \frac{N_q(p)}{S_q(p)}} \qquad (3)$$

where $S_q(p)$, $N_q(p)$ denote the power associated to the generic sample of the signal or of the noise in the q-th frequency band, in the p-th frame or segment; Q is the number of frequency bands (articulatory bands) into which the spectrum of the test signal is divided (e.g.

16 bands), and P is again the number of segments.

For frequency weighted measurements also other definitions are possible; anyway the one reported here has given a good correlation with subjective measurements for the widest range of speech coders.

The functional structure of circuits that can compute quantities SNR, SNRS, SNRF will be described with reference to Figures 3, 4, 5.

To make the drawing simpler neither the analog-to-digital converters, necessary when the signals emitted by TL or GS are not digital, nor the means allowing the selection by the operator of the signal generator or of the unwanted measurement device have been represented in Fig. 1.

Fig. 2 shows that filter FA consists of a conventional 2 M-cell transversal filter (i.e. a filter comprising 2 M−1 delay elements RT, 2M multipliers ML and an adder S1) in which each of the variable coefficients for weighting the samples is supplied by a circuit CC (only one of them being shown in the Figure) for coefficients processing on the basis of the sample to be weighted (present on wire 1) and of the first error signal $e_n$ (present on wire 4).

In the coefficient processing circuit a first multiplier M1 multiplies the first error signal by an adaptation constant $\beta_n$, that will be disclosed hereinafter; a second multiplier M2 has its two inputs connected to input 1 of the filter and to the output of M1, respectively, and supplies at the output the product between the arriving sample and the signal outgoing from M1; the output of M2 is connected to an input of an adder S2 which receives at a second input the value of the coefficient at the previous instant, supplied by a delay element RT, connected between the output and the second input of S2.

The generic adaptation constant $\beta_n$ is given by relation

$$\beta_n = \frac{2\alpha}{+M \atop \sum_{i=-M} r^2_{n-i}}$$

where $r_{n-i}$ is the generic sample of the input signal and $\alpha$ is the adaptation step, whose value depends on the desired adaptation velocity and ranges from 0 to 1. A certain number of values of $\alpha$ can be advantageously set from the outside, so as to increase the flexibility of the measuring device.

The circuit for coefficient processing operates therefore according to the relation

$$C_k^{n+1} = C_k^n + \frac{2\alpha}{\sum\limits_{i=-M}^{M} r^2_{n-i}} e_n \cdot r_{n-k} \qquad (4)$$

where $C_k^n$, $C_k^{n+1}$ ... are the values at instants $nT$, $(n+1) T$ ... of generic coefficient $C_k$, and $r$ is still the signal sample.

According to Fig. 3, the measuring circuit MQ1 for computing the total signal-to-noise ratio comprises a pair of accumulating multipliers MA1, MA2 that receive the samples of the reference signal (wire 3) and of the noise (second error signal on wire 4) respectively and sum the squares of the values of such samples for the whole test duration. The outputs of multipliers MA1, MA2 are connected to a circuit SN1, that supplies at the output the value of the signal-to-noise ratio in decibels. That value is supplied to a circuit CQ1 that computes the quality value, as previously said.

The values supplied by SN1, and CQ1 could be displayed to the operator by any displaying means, not shown.

According to Fig. 4, the measuring circuit MQ2 for computing the segmental signal-to-noise ratio comprises two accumulating multipliers MA3, MA4, similar to MA1, MA2, that sum the squares of the samples for each segment into which the test period is divided.

The output of MA3 is connected to a threshold circuit CS1 that lets through only the output signals of MA3 relevant to segments in which the signal power exceeds a predetermined value (e.g. $-54$ dBm). Circuits CS1 drives a switch IN connected to the output of MA4, causing it to open whenever the signal power is below the threshold: in this way the measurement is not carried out for instance during pauses, in which any noise, even if small, would result in very small values of signal-to-noise ratio, badly effecting the measurement even if the quality is not actually impaired.

The output of CS1 is connected to an input of a ratio computing circuit SN2, that has a second input connected, through IN, to the output of MA4. For each segment, SN2 computes the value of the signal-to-noise ratio. The values computed by SN2 are supplied to a device MP1 that computes the weighted mean.

Also in this case the quality indication is obtained from the weighted mean (by means of circuit CQ2). This indication is supplied to the display in alternative or in addition to the value of signal-to-noise ratio.

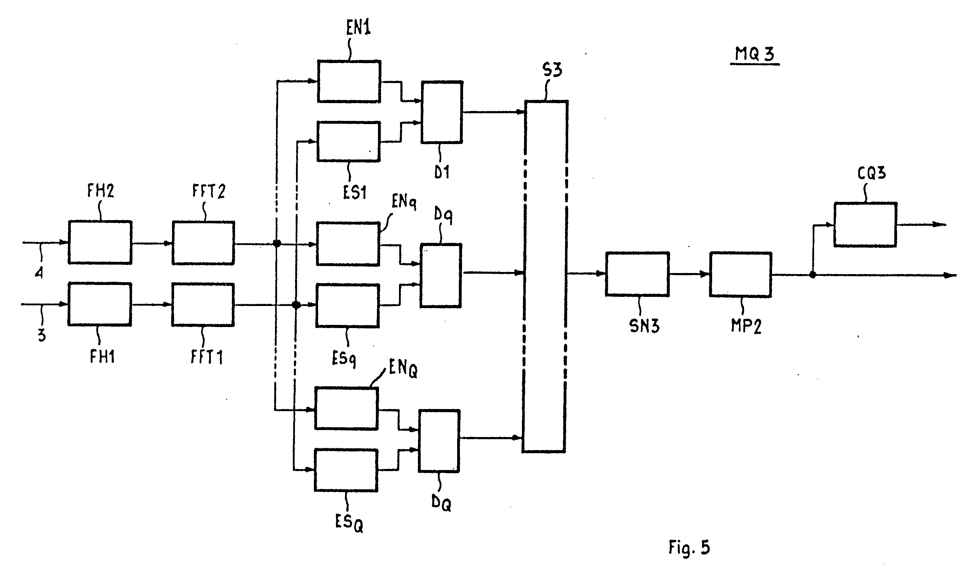

According to Fig. 5, the measuring circuit MQ3 for computing the frequency weighted segmental signal-to-noise ratio comprises two identical circuits FH1, FH2 that, in each of the segments into which the test period is divided, multiply the reference signal and the respective noise for so-called "Hamming window": in this way sample frames with a length suitable for the computation of the fourier transform can be obtained (e.g. frames of 128 samples) and the division into frames is performed without negatively affecting the transform computation.

The sample frames outgoing from FH1, FH2 are sent respectively into devices FFT1, FFT2 that compute the fast Fourier transform of said samples and supply at the output the corresponding samples in the frequency domain.

Devices FFT1, FFT2 are followed by a plurality of devices ES1 ... ESq ... ESQ, and respectively EN1 ... ENq ... ENQ each computing the power associated to the signal samples (blocks ES) or to the noise samples (blocks EN) in each of the articulatory bands (usually 16) into which the band of the transmitted signal is divided. More particularly, circuits ES, EN will sum the squares of the moduli of the numbers representing said samples.

The outputs of blocks ES, EN relevant to the same articulatory bands are connected to dividers D1 ... Dq ... DQ, that for each band supply the value of the ratio between the noise power and the signal power; the outputs of the dividers are combined together in an adder S3 whose output is connected to a circuit SN3 that, for each segment, supplies a value in dB given by the term

$$10 \, \mathrm{Log} \, \cfrac{1}{1 + \sum\limits_{q=1}^{Q} \cfrac{N_q(p)}{S_q(p)}}$$

of relation (3; circuit SN3 is followed by circuit MP2 that calculates the weighted mean of the values relevant to various segments.

As in the previous cases, from the value of signal-to-noise ratio the quality indication is extracted (block CQ3) that is sent to the display together with the indication in dB.

It will be noted that the diagrams of Figs. 3, 4, 5 are operating diagrams. In the practical realization, as all blocks must effect only mathematical operations defined by previous relations (1), (2), (3) and operate on numbers, the functions of the various devices can be carried out by suitable programs stored in a program memory, e.g. of a microprocessor. It is then clear how easy it is to pass from a kind of measurement to another one or to provide for other kinds of measurements.

The operation of the device will be described now; for description simplicity and clearness, reference is made to the measurement of segmental signal-to-noise ratio for a differential speech coder, which is the system CD under test.

As mentioned, quality measurement is effected in two different phases: in a first phase the characteristics of the unknown transmission system are identified, and in the second phase the quality value is computed. In the first phase the operator connects to the input of filter FA and of coder CD (Fig. 1) the white noise generator making part of GS sets a suitable value of coefficient $\alpha$ for the adaptation of FA and leaves measuring means MQ unconnected. The white noise is sent into coder CD and filter FA; said filter weights the samples of the input signal with suitable coefficients and supplies on its output 3 a sample that is subtracted from the coder output signal to give the first error signal that modifies the values of the weighting coefficients according to relation (4).

After a time that depends on the value set for coefficient $\alpha$ (for instance few seconds) the first error signal becomes negligible: this means that the filter truly reproduces the characteristics of the linear parts of the coder under test, ensuring also synchronization between coder input and output. The adaptation is now stopped, so that filter FA will operate as simple transversal filter, with the values of the coefficients supplied by devices CC (Fig. 2) at the instant when adaptation was stopped; this can be obtained for instance by setting a value 0 for coefficient $\alpha$ (and then for updating step $\beta$).

Stopping the adaptation of filter FA corresponds to beginning the second, i.e. the very measuring phase.

For this phase the selected measuring circuit, in particular circuit MQ2 of Fig. 4, is connected to filter FA and to subtractor ST1. In addition the white noise generator is switched off and the generator of the artificial speech-like signal is switched on.

As in the first, i.e. the identification phase, the test signal is sent to both the coder and the filter and now the second error signal is obtained from ST1; the filter output signal and the second error signal are sent to measuring device MQ2 that computes the segmental signal-to-noise ratio according to relation (2) and quality value IQ according to the relation IQ=a SNRS+b, with a=0,31 and b=0,89, as mentioned in the paper of B. McDermott et al.

The value of SNRS in dB and/or the quality indication can then be displayed.

Due to the quasi-stationarity of the artificial signal, this measuring phase can last from a fraction of a second to few seconds, depending on whether a constant or a variable envelope is used.

The use of the artificial signal of the described type allows the attainment of an average evaluation with respect to the different evaluations that can be obtained by real speech signals, as those supplied by TL; however, whenever required, for instance for research requirements, filter FA and coder CD can be connected to source TL, that can be a recorder, a microphone or any other device; of course, if external source TL is used its signals must be converted into digital form, in case CD operates on digital inputs.

In the described embodiment two different signals for the two operating phases have been used; experimental tests have however demonstrated that, even though the use of a white noise (that has no periodicity characteristics) makes the attainment of a good identification easier, the use of one and the same signal for the identification and for the measurement is equivalent or even preferable for the subsequent objective measurements.

What stated for quality measurements in terms of segmental signal-to-noise ratio can be repeated unchanged for the measurement of total signal-to-noise ratio or for frequency weighted measurements; in the latter case, as mentioned, the artificial signal can not be used, and a non-stationary signal such as speech or certain shaped noises with short term variable spectrum must be used.

The availability of different sources and different measuring circuits may be exploited to effect different measurements on the same system. By linearly combining the different quality indications obtained with relations like that giving the objective quality as function of the signal-to-noise ratio, a high correspondance with the subjective indications is obtained. The versality of the invention, that exploiting the identification technique is apt to effect quality measurements on different kinds of systems over a wide range of values for instance of the signal-to-noise ratio, is apparent from the above description.

It is to be noted that the greater the signal-to-noise ratio, the greater the bit number on which the device must operate: this could lead to some circuit complexity. Yet the problems stated in the introduction are particularly serious for low or medium rate apparatuses in which signal-to-noise ratio does not generally exceed some thirty dB; therefore the proposed method and device find their natural application in that field.

## Claims

1. Method of carrying out objective measurements on a digital speech transmission system (CD) characterised in that it comprises in a first operating phase the steps of:

— generating and sending into the system samples of a first test signal,
— identifying the characteristics of the linear part of said system, by repetitively weighting different sets of said samples of said first test signal in a linear adaptive transversal filter (FA) with coefficients which are progressively modified on the basis of a first error signal which is the difference between the output signal (2) of the system and the output signal (3) of the filter in response to said sets of samples of said first test signal, and
— storing the coefficients that minimize the first error signal,

and in a second phase the steps of:

— generating and sending into the system samples of a second test signal,
— weighting the samples of said second test signal in said filter with the coefficients that have minimized the first error signal,
— generating a second error signal which is the difference between the output signal of the system and the output signal of the filter in response to the samples of the second test signal, and
— obtaining at least one digital quality value by combining the second error signal and the output signal of the filter in response to the samples of the second test signal.

2. Method according to claim 1, characterized in that the filter coefficients are updated according to a relation of the kind:

$$C_k^{n+1}=C_k^n+\frac{2\alpha}{\displaystyle\sum_{i=-M}^{M} r_{n-i}^2}\, e_n \cdot r_{n-k}$$

where

$C_k^n$, $C_k^{n+1}$ ... are the values of the k-th coefficient at instants $nT$ and $(n+1)T$, respectively, $T$ being the sampling period of the samples of the first test signal;

$r_{n-i}$, $r_{n-k}$ are the samples of the first test signal at instants $(n-i)T$, $(n-k)T$;

$2M$ is the total number of the coefficients $C_k$;

$\alpha$ is the adaptation step, with value ranging from 0 to 1, that can be selected on the basis of the kind of system and of quality value measurement; $e_n$ is the first error signal after the $n^{th}$ sampling period.

3. Method according to claims 1 or 2, characterized in that said quality value is obtained from evaluations of signal-to-noise ratio, in which the output signal of the filter in response to the samples of the second test signal is used as reference signal and the second error signal is used as noise.

4. Method according to claims 1 to 3, characterized in that different quality values are obtained for a same system under test and in that a linear combination of the different measurements is effected.

5. Method according to claim 3, characterized in that said evaluations of signal-to-noise ratio comprise at least the evaluation of total signal-to-noise ratio and of segmental signal-to-noise ratio and the frequency weighting of segmental signal-to-noise ratio.

6. Method according to claims 1 to 4, characterized in that the first and second test signals are chosen among: sinusoids, white noise, frequency shaped noise, periodic or slowly variable artificial speech-like signals, real speech.

7. Device for carrying out the method according to any one of claims 1 to 6, characterized in that it comprises:

— means (GS) for generating first and second test signals arranged to be connected to a digital speech transmission system as an alternative to a real speech source (TL),
— means for sampling said first and second test signals,
— a linear adaptive transversal filter (FA), which is connected in parallel to the system (CD) and which in the first operating phase identifies the characteristics of the linear part of the system by repetitively weighting different sets of said samples of the first test signal in the filter by coefficients that are progressively modified on the basis of a first error signal represented by the difference between the output signal (2) of the system and the output signal (3) of the filter in response to said sets of samples of the first test signal, while in a second operating phase it gives an output signal which corresponds to the samples of the second test signal after weighting thereof in said filter by the fixed coefficients obtained as a result of the first operating phase,
— a subtractor (ST1), that receives the output signals of the system and of the filter and produces said first error signal and a second error signal in the first and second operating phase respectively, said second error signal being represented by the difference between the output signal (2) of the system and the output signal (3) of the filter in response to the samples of the second test signal,
— means (MQ) which are connected during the second phase to the outputs of the filter and of the subtractor to determine at least one objective quality value on the basis of the second error signal and the output signal of the filter in response to the samples of the second test signal.

8. Device according to claim 7, characterized in that the means (GS) generating the test signals comprises at least: a generator of sinusoidal functions, a generator of white noise, a generator of frequency-shaped noise and a generator of periodic artificial signals having the spectral characteristics of the average speech.

9. Device according to claim 8, characterized in that said generator of periodic artificial signals is associated to a generator of slowly varying signals and to means designed to effect the product between said periodic artificial signals and said slowly varying signals.

10. Device according to claim 7, characterized in that the means (MQ) determining the quality value comprise a plurality of devices (MQ1, MQ2, MQ3) each apt to effect a different kind of quality measurement.

11. Device according to claim 7, characterized in that the means determining the quality value comprise a programmable computation device, with a program memory containing programs for the effectuation of different types of quality measurements.

12. Device according to any of claims 7, 10, 11 characterized in that the means (MQ) determining the quality value provides a quality indication from evaluations of the signal-to-noise ratio, the signal and the noise being represented by the filter output signal and by the second error signal, respectively.

13. Device according to claim 12, characterized in that the means (MQ) determining the quality value comprises means for computing the total and the segmental signal-to-noise ratio and the frequency weighted segmental signal-to-noise ratio.

14. Device according to any of claims 10 to 13, characterized in that means are provided to linearly combine quality values obtained as results of different measurements on the same system.

15. Device according to any one of claims 7 to 14, characterized in that said system is a speech coder.

## Revendications

1. Procédé pour effectuer des mesures objectives en un système (CD) de transmission numérique de la voix, caractérisé en ce qu'il comprend, dans une première phase de travail, les opérations suivantes:

— engendrer et envoyer dans le système des échantillons d'un premier signal d'essai;
— identifier les caractéristiques de la partie linéaire dudit système au moyen de la pondération répétée de groupes différents desdits échantillons dudit premier signal d'essai, dans un filtre transversal linéaire et adaptable (FA), avec des coefficients qui sont modifiées progressivement d'après un premier signal d'erreur représenté par la différence entre le signal de sortie (2) du système et le signal de sortie (3) du filtre en réponse auxdits groupes d'échantillons dudit premier signal d'essai; et
— mémoriser les coefficients qui minimisent le premier signal d'erreur;

et, dans une second phase, les opérations suivantes:

— engendrer et envoyer dans le système des échantillons d'un second signal d'essai;
— pondérer les échantillons dudit second signal d'essai dans ledit filtre avec les coefficients qui ont minimisé le premier signal d'erreur;
— engendrer un second signal d'erreur représenté par la différence entre le signal de sortie du système et le signal de sortie du filtre en réponse aux échantillons du second signal d'essai; et
— obtenir au moins une valeur numérique de la qualité en combinant le second signal d'erreur et le signal de sortie du filtre en réponse aux échantillons du second signal d'essai.

2. Procédé suivant la revendication 1, caractérisé en ce que les coefficients du filtre sont mis à jour suivant une relation du genre suivant:

$$C_k^{n+1} = C_k^n + \frac{2\alpha}{\displaystyle\sum_{i=-M}^{M} r_{n-i}^2} \cdot e_n \cdot r_{n-k}$$

où $C_k^n$, $C_k^{n+1}$ sont les valeurs du k'ème coefficient aux instants $nT$ et $(n+1)T$, respectivement, $T$ étant la période d'échantillonnage des échantillons du premier signal d'essai; $r_{n-i}$, $r_{n-k}$ sont les échantillons du premier signal d'essai aux instants $(n-i)T$, $(n-k)T$; $2M$ est le nombre total des coefficients $C_k$; $\alpha$ est le pas d'adaptation dont la valeur est comprise dans la gamme 0 à 1 et qui peut être sélectionné suivant le genre de système et de mesure de la qualité; $e_n$ est le premier signal d'erreur, après la n-ème période d'échantillonnage.

3. Procédé suivant les revendications 1 ou 2, caractérisé en ce que ladite valeur de qualité est calculée à partir d'évaluations du rapport signal-bruit, en employant comme signal de référence le signal de sortie du filtre en réponse aux échantillons du second signal d'essai et comme bruit le signal signal d'erreur.

4. Procédé suivant les revendications 1 à 3, caractérisé en ce que l'on obtient différentes valeurs de la qualité pour le même système à tester et en ce que l'on combine linéairement les différentes mesures.

5. Procédé suivant la revendication 3, caractérisé en ce que lesdites évaluations du rapport signal-bruit comprennent au moins la évaluation du rapport signal-bruit global et du rapport signal-bruit segmenté et la pondération en fréquence du rapport signal-bruit segmenté.

6. Procédé suivant l'une quelconque des revendications 1 à 4, caractérisé en ce que le premier et second signal d'essai sont choisis parmi: sinusoides, bruit blanc, bruit à spectre modelé, signaux vocaux artificiels périodiques ou variables lentement, voix réelle.

7. Dispostif pour réaliser le procédé suivant les revendications 1 à 6, caractérisé en ce qu'il comprend:

— des moyens (GS) pour engendrer un premier et un second signal d'essai, connectables à un système de transmission numérique de la voix alternativement à une source de voix réelle;
— des moyens pour échantillonner lesdits premier et second signaux d'essai;
— un filtre transversal linéaire adaptable (FA) qui est connecté en parallèle au système (CD) et qui dans une première phase de travail, identifie les caractéristiques de la partie linéaire du système en pondérant de façon répétée dans le filtre des groupes différents desdits échantillons du premier signal d'essai avec des coefficients qui sont modifiés progressivement d'après un premier signal d'erreur représenté par la différence entre le signal de sortie (2) du système et le signal de sortie (3) du filtre en réponse auxdits groupes d'échantillons du premier signal d'essai, tandis que dans une seconde phase de travail il donne un signal de sortie qui correspond aux échantillons du second signal d'essai après les pondération dans le filtre avec les coefficients fixes obtenus comme résultat de la première phase de travail;

— un circuit soustractif (ST1) qui reçoit le signal de sortie du système et du filtre et qui engendre ledit premier signal d'erreur et un second signal d'erreur dans la première et la seconde phase de travail, respectivement, ledit second signal d'erreur étant représenté par la différence entre le signal de sortie (2) du système et le signal de sortie (3) du filtre en réponse aux échantillons du second signal d'essai;

— des moyens (MQ) qui pendant la seconde phase sont connectés à la sortie du filtre et du circuit soustractif pour déterminer au moins une valeur objective de la qualité d'après le second signal d'erreur et le signal de sortie du filtre en réponse aux échantillons du second signal d'essai.

8. Dispositif suivant la revendication 7, caractérisé en ce que les moyens (GS) pour engendrer les signaux d'essai comprennent au moins un générateur de fonctions sinusoïdales, un générateur de bruit blanc, un générateur de bruit à spectre modelé et un générateur de signaux artificiels périodiques ayant les mêmes caractéristiques spectrales que la voix moyenne.

9. Dispositif suivant la revendication 8, caractérisé en ce que le générateur de signaux artificiels périodiques est associé à un générateur de signaux lentement variables et à des moyens pour effecteur le produit entre les signaux artificiels périodiques et les signaux lentement variables.

10. Dispositif suivant la revendication 7, caractérisé en ce que les moyens (MQ) pour la détermination de la valeur de la qualité comprennent une pluralité d'organes (MQ1, MQ2, MQ3) dont chacun est apte à effecteur un type différent de mesure de la qualité.

11. Dispositif suivant la revendication 7, caractérisé en ce que les moyens pour la détermination de la valeur de la qualité comprennent un organe du calcul programmable, avec une mémoire programmes qui contient des programmes pour l'effectuation de types différents de mesure de la qualité.

12. Dispositif suivant l'une quelconque des revendications 7, 10, 11, caractérisé en ce que les moyens (MQ) pour la détermination de la valeur de la qualité donnent une indication de qualité a partir d'évaluations du rapport signal-bruit, le signal et le bruit étant représentés respectivement par le signal de sortie du filtre et par le second signal d'erreur.

13. Dispositif suivant la revendication 12, caractérisé en ce que les moyens (MQ) pour la détermination de la valeur de la qualité comprennent des moyens pour l'évaluation du rapport signal-bruit total et segmenté et du rapport signal-bruit segmenté pondéré en fréquence.

14. Dispositif suivant l'une quelconque des revendications 10 à 13, caractérisé en ce qu'il comprend des moyens pour combiner linéairement les valeurs de la qualité obtenues comme résultat de mesures diverses sur le même système.

15. Dispositif selon l'une quelconque des revendications 7 à 14, caractérisé en ce que ledit système est un codeur de la voix.

**Patentansprüche**

1. Verfahren zur Durchführung objektiver Messungen an einem digitalen Sprachübertragungssystem (CD), dadurch gekennzeichnet, daß man in einer ersten Betriebsphase die folgenden Schritte durchführt:

— man erzeugt Abtastwerte eines ersten Testsignals und sendet sie in das System;
— man identifiziert die Charakteristiken des linearen Teils des Systems durch wiederholte Gewichtung unterschiedlicher Gruppen der Abtastwerte des ersten Testsignals in einem linearen adaptiven Transversalfilter (FA) mot Koeffizienten, die auf der Grundlage eines ersten Fehlersignals fortschreitend modifiziert werden, das die Differenz zwischen dem Ausgangssignal (2) des Systems und dem Ausgangssignal (3) des Filters in Antwort auf die Gruppen von Abtastwerten des ersten Testsignals ist;
— man speichert die Koeffizienten, bei denen das erste Fehlersignal minimal ist;

und daß man in einer zweiten Betriebsphase die folgenden Schritte durchführt:

— man erzeugt Abtastwerte eines zweiten Testsignals und sendet sie in das System;
— man gewichtet die Abtastwerte des zweiten. Testsignals im Filter mit denjenigen Koeffizienten, bei denen das erste Fehlersignal minimal war;
— man erzeugt ein zweites Fehlersignal, das die Differenz zwischen dem Ausgangssignal des Systems und dem Ausgangssignal des Filters in Antwort auf die Abtastwerte des zweiten Testsignals ist; und
— man erhält durch Kombinieren des zweiten Fehlersignals und des Ausgangssignals des Filters in Antwort auf die Abtastwerte des zweiten Testsignals wenigstens einen digitalen Gütewrt.

2. Verfahren nach Anspruch 1, dadurch gekennzeichnet, daß man die Filterkoeffizienten gemäß der nachfolgenden Beziehung fortschreibt:

$$C_k^{n+1} = C_k^n + \frac{2\alpha}{\displaystyle\sum_{i=-M}^{M} r_{n-i}^2} \, e_n \cdot r_{n-k}$$

wobei

$C_k^n, C_k^{n+1} \ldots$ = Werte des k-ten Koeffizienten zu Zeitpunkten nT bzw. (n+1)T;

T = Abtastperiode der Abtastungen des ersten Testsignals;

$r_{n-i}, r_{n-k}$ = Abtastwerte des ersten Testsignals zu Zeitpunkten (n-i)T, (n-k)T;

2M = Gesamtzahl der Koeffizienten $C_k$;

$\alpha$ = Adaptionsschritt mit Werten von 0 bis 1, die auf der Grundlage der Art des Systems und der Gütewertmessung wählbar sind; und

$e_n$ = das erste Fehlersignal nach der n-ten Abtastperiode.

3. Verfahren nach den Ansprüchen 1 oder 2, dadurch gekennzeichnet, daß man den Gütewert aus Auswertungen des Signal-zu-Rausch-Verhältnisses erhält, wobei das Ausgangssignal des Filters in Antwort auf die Abtastwerte des zweiten Testsignals als Bezugssignal und das zweite Fehlersignal als Rauschsignal verwendet werden.

4. Verfahren nach den Ansprüchen 1 bis 3, dadurch gekennzeichnet, daß man verschiedene Gütewerte für ein selbes zu testendes System erhält und die verschiedenen Messungen linear kombiniert.

5. Verfahren nach Anspruch 3, dadurch gekennzeichnet, daß man wenigstens die folgenden Auswertungen des Signal-zu-Rausch-Verhältnisses durchführt: Auswertung des totalen Signal-zu-Rausch-Verhältnisses, des segmentellen Signal-zu-Rausch-Verhältnisses und einer Frequenzgewichtung des segmentellen Signal-zu-Rausch-Verhältnisses.

6. Verfahren nach den Ansprüchen 1 bis 4, dadurch gekennzeichnet, daß man das erste und das zweite Testsignal unter folgenden Signalen auswählt: Sinussignale, weißes Rauschen, frequenzgeformtes Rauschen, periodische oder langsam veränderliche künstliche sprachartige Signale, tatsächliche Sprache.

7. Vorrichtung zur Durchführung des Verfahrens nach einem der Ansprüche 1 bis 6, gekennzeichnet durch

— eine alternativ zu einer tatsächlichen Sprachquelle (TL) mit einem digitalen Sprachübertragungssystem verbindbare Einrichtung (GS) zum Erzeugen des ersten und des zweiten Testsignals;

— eine Einrichtung zum Abtasten des ersten und des zweiten Testsignals;

— ein lineares adaptives Transversalfilter (FA), das parallel zum System (CD) geschaltet ist und das in der ersten Betriebsphase die Charakteristiken des linearen Teils des Systems durch wiederholtes Gewichten unterschiedlicher Gruppen der Abtastwerte des ersten Testsignals im Filter mit Koeffizienten, die auf der Basis eines ersten Fehlersignals fortschreitend modifiziert werden, das vom Unterschied zwischen dem Ausgangssignal (2) des Systems und dem Ausgangssignal (3) des Filters in Antwort auf die Gruppen von Abtastwerten des ersten Testsignals dargestellt wird, identifiziert, während es in einer zweiten Betriebsphase ein Ausgangssignal abgibt, des den Abtastwerten des ersten Testsignals nach deren Gewichtung im Filter mit den festen Koeffizienten, die als Ergebnis der ersten Betriebsphase erhalten wurden, entspricht;

— einen Subtraktor (ST1), der die Ausgangssignale des Systems und des Filters empfängt und das erste Fehlersignal und ein zweites Fehlersignal in der ersten bzw. in der zweiten Betriebsphase liefert, wobei das zweite Fehlersignal von der Differenz zwischen dem Ausgangssignal (2) des Systems und dem Ausgangssignal (3) des Filters in Antwort auf die Abtastwerte des zweiten Testsignals dargestellt wird;

— eine mit den Ausgangsklemmen des Filters und des Subtraktors während der zweiten Phase verbundene Einrichtung (MQ), die wenigstens einen objektiven Gütewert auf der Grundlage des zweiten Fehlersignals und des Ausgangssignals des Filters in Antwort auf die Abtastungen des zweiten Testsignals bestimmt.

8. Vorrichtung nach Anspruch 7, dadurch gekennzeichnet, daß die die Testsignale erzeugende Einrichtung (GS) wenigstens folgende Generatoren umfaßt: einen Generator sinusoidaler Funktionen, einen Generator von weißem Rauschen, einen Generator von frequenzmoduliertem Rauschen und einen Generator periodischer künstlicher Signal mit den spektralen Charakteristiken der Durchschnittssprache.

9. Vorrichtung nach Anspruch 8, dadurch gekennzeichnet, daß der Generator der periodischen künstlichen Signale einem Generator langsam sich ändernder Signale und einer Einrichtung, die das Produkt zwischen den periodisch künstlichen Signalen und den sich langsam ändernden Signalen erzeugt, zugeordnet ist.

10. Vorrichtung nach Anspruch 7, dadurch gekennzeichnet, daß die den Gütewert angebende Einrichtung (MQ) eine Mehrzahl von Einzelvorrichtungen (MQ1, MQ2, MQ3) umfaßt, von den jede eine andere Art der Gütemessung durchführt.

11. Vorrichtung nach Anspruch 7, dadurch gekennzeichnet, daß die den Gütewert angebende Einrichtung eine programmierbare Rechenvorrichtung mit einem Programmspeicher umfaßt, der Programme für die Durchführung verschiedener Arten von Gütemessungen enthält.

12. Vorrichtung nach einem der Ansprüchen 7, 10 und 11, dadurch gekennzeichnet, daß die den Gütewert angebende Einrichtung (MQ) eine Güteanzeige durch Auswertungen des Signal-zu-Rausch-Verhältnisses erbringt, wobei das Signal durch das Filterausgangssignal und das Rauschen durch das zweite Fehlersignal dargestellt sind.

13. Vorrichtung nach Anspruch 12, dadurch gekennzeichnet, daß die den Gütewert angebende Einrichtung (MQ) Einrichtungen zum Berechnen des gesamten und des segmentellen Signal-zu-Rausch-Verhältnisses und des frequenzgewichteten segmentellen Signal-zu-Rausch-Verhältnisses enthält.

14. Vorrichtung nach einem der Ansprüche 10 bis 13, dadurch gekennzeichnet, daß eine Einrichtung zum linearen Kombinieren der als Ergebnisse verschiedener Messungen am selben System erhaltenen Gütewerte vorhanden ist.

15. Vorrichtung nach einem der Ansprüche 7 bis 14, dadurch gekennzeichnet, daß das zu testende System ein Sprachkodierer ist.

0 030 724

Fig.1

FA

Fig. 2

MQ 1

Fig. 3

MQ 2

Fig. 4

MQ 3

Fig. 5

CQ3 · MP2 · SN3 · S3 · D1 · Dq · DQ · EN1 · ES1 · ENq · ESq · ENQ · ESQ · FFT2 · FFT1 · FH2 · FH1